(19) Europäisches Patentamt / European Patent Office / Office européen des brevets

(11) **EP 3 244 557 A1**

(12) **EUROPEAN PATENT APPLICATION**

(43) Date of publication:
**15.11.2017 Bulletin 2017/46**

(51) Int Cl.:
*H04J 3/14* (2006.01)  *G01R 25/00* (2006.01)
*H04J 3/06* (2006.01)  *H03D 13/00* (2006.01)

(21) Application number: **16305548.6**

(22) Date of filing: **11.05.2016**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(71) Applicant: **ALCATEL LUCENT
92100 Boulogne-Billancourt (FR)**

(72) Inventor: **KOCH, Werner
70435 Stuttgart (DE)**

(74) Representative: **MERH-IP Matias Erny Reichl
Hoffmann
Patentanwälte PartG mbB
Paul-Heyse-Strasse 29
80336 München (DE)**

(54) **METHOD AND APPARATUS FOR FREQUENCY SUPERVISION**

(57) This application relates to a method for supervising a frequency of a main clock signal. The method comprises: measuring a plurality of first frequency values of the main clock signal based on an external time signal, measuring a plurality of second frequency values of the main clock signal based on a local reference signal, comparing the measured plurality of first frequency values of the main clock signal, comparing the measured plurality of second frequency values of the main clock signal, determining a relative long-term frequency change between the main clock signal and the external time signal based on the comparison of the measured plurality of first frequency values of the main clock signal and determining whether a relative frequency change exists between the main clock signal and the local reference signal based on the comparison of the measured plurality of second frequency values of the main clock signal. The application further relates to a frequency supervision apparatus for supervising a frequency of a main clock signal.

200

Fig. 2

## Description

## Technical Field

This application relates to generation of a highly accurate and stable oscillator source for a digital system, and more particularly, to precise and reliable measurement and supervision of oscillator frequencies which may be slightly drifting away during operation of the digital system.

## Background

Modern digital systems utilize many electronic components consisting of various digital circuitry. As the plurality of electronic components of a digital system need to be interconnected to perform the required function in the digital system, it is necessary to enable these electronic components to communicate each other and, in particular, to establish synchronization between various digital circuitry of these electronic components. Therefore, in order to properly operate a digital system, a basic requirement of every digital circuitry is a stable working clock. For example when developing equipment for high-speed optical transmission, the essential element is a highly stable internal oscillator to be used as a source of internal working clock and for generating outgoing signals. Since the precise specification for operation of the whole system needs to be kept over long time, reliable frequency supervision of the clock is required and therefore the frequency of the clock signal must be carefully measured in order to properly monitor any failure of oscillator(s).

Typically a clock source is provided by a crystal oscillator which generates a stable clock signal with the required precision. According to the stability requirement by ITU-T, the best solution for generating a highly stable clock source is to use an Oven Controlled Crystal Oscillator (OCXO) as an internal oscillator of the system, because crystal oscillators in general have very high quality factor (Q), i.e. a highly precise and stable resonance frequency and a narrow resonance width, and further applying the design that encloses the crystal in a temperature-controlled chamber, i.e. an oven, can reduce environmental effects caused by such as temperature, humidity, pressure, vibration etc.

Furthermore, clock redundancy comprising multiple oscillators can be applied in a system to continuously provide a stable clock signal in case one of the oscillators fails. According to related art, the frequency of an oscillator can be measured, for example, by a direct count method that counts the number of oscillations coming from the oscillator within a predetermined gate time. Normally such measurements apply an internal or external time-base oscillator working precisely and stably as a reference signal to provide the predetermined gate time. In other words, a superior grade instance is needed in order to achieve frequency supervision function of a crystal oscillator and the superior grade instance must be supervised by the next higher instance and so on.

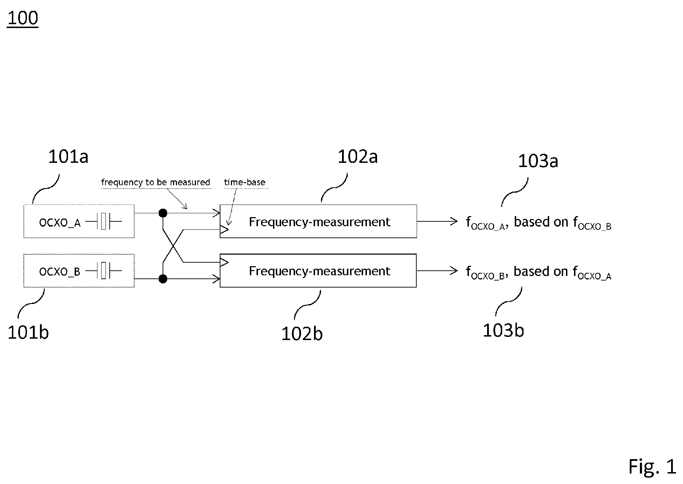

In a clock-redundancy configuration **100** as shown in **Fig. 1** where two OCXOs A **101a** and B **101b** are applied, a mutual supervision of OCXOs' frequency is implemented by measuring the frequency of the OCXO A **101a** based on the frequency of the OCXO B **101b** with a frequency measuring device for OCXO A **102a** and by measuring the frequency of the OCXO B **101b** based on the frequency of the OCXO A **101a** with a frequency measuring device for OCXO B **102b.** In general, measuring the frequency of a signal "based on" another signal means to take the other signal as reference, and the measured frequency of the signal is related to the frequency difference between the two signals, i.e. the measured frequency drift of the signal depends on the frequency drift of the other signal. As illustrated in **Fig. 1,** the OCXO A **101a** and OCXO B **101b** serve as the time-base sources for the frequency measuring devices for OCXO B **102b** and OCXO A **102a,** respectively. The result of both frequency measurements thus represents the difference between the two OCXO frequencies $f_{OCXO\_A}$ and $F_{OCXO\_B}$, i.e. a relative value of their frequency offsets based on each other. For example, if $f_{OCXO\_A}$ and $F_{OCXO\_B}$ are deviated from their nominal frequency by an offset of -7 ppm and +4 ppm, respectively, measured $F_{OCXO\_A}$, based on $F_{OCXO\_B}$ **103a** and measured $F_{OCXO\_B}$, based on $f_{OCXO\_A}$ **103b** are therefore deviated by an offset of - 11 ppm and + 11 ppm accordingly assuming they have the same nominal frequency. However, a third "superior grade instance" is necessary for calculating an absolute value of their frequency offsets and measuring frequency changes of the oscillators can thus be accomplished through an external reference source, e.g. a third OCXO with very high stability which serves as the "superior grade instance".

Nevertheless, the problem is the required high accuracy of the external reference which must be significantly better than the OCXO-accuracy. Because the accuracy of an OCXO is - typically - about 2~3 ppm, the required external reference accuracy should be smaller than 0.5 ppm, which is not available in most cases. Further, although an external reference can be used as a superior grade instance, in many situations the equipment cannot work with an external reference. Besides, if the oscillator frequency in transmission equipment is drifting away, no direct detection of frequency drifts is possible.

Thus, there is a need to accurately measure frequency drifts of oscillators in equipment without a "superior grade instance", thereby generating a precise and stable system clock without support of an external reference clock. There is also a need for investigations of reliable OCXO supervision that can precisely detect a small drift in an OCXO frequency without a superior grade instance.

**Summary**

In view of these needs, the present document proposes a supervision method and apparatus having the features of the respective independent claims for supervising a frequency of a main clock signal, where the main clock signal may be used as an internal clock source of a digital system, e.g. transmission equipment. The main clock signal may be provided by, for example, a crystal oscillator and may have a level varying repeatedly between a high and a low state which results in one or more cycles.

An aspect of the disclosure relates to a frequency supervision method. The method may comprise measuring a plurality of first frequency values of the main clock signal based on an external time signal. The method may comprise measuring a plurality of second frequency values of the main clock signal based on a local reference signal. More specifically, measuring the first frequency values of the main clock signal based on the external time signal may comprise taking the external time signal as reference, and the measured first frequency values of the main clock signal may be related to the frequency difference between the main clock signal and the external time signal, i.e. the measured frequency drift in the first frequency values of the main clock signal may depend on the frequency drift of the external time signal. Similarly, measuring the second frequency values of the main clock signal based on the local reference signal may comprise taking the local reference signal as reference, and the measured second frequency values of the main clock signal may be related to the frequency difference between the main clock signal and the local reference signal, i.e. the measured frequency drift in the second frequency values of the main clock signal may depend on the frequency drift of the local reference signal. According to the present application, the external time signal may be configured to provide time of day information with long-term stability. The external time signal may be a long-term stable signal but not necessarily a short-term stable signal. The external time signal may comprise a network-based time signal with long-term stability which may be provided according to a Network Timing Protocol (NTP). According to the present application, the local reference signal may be provided by a crystal oscillator with short-term stability. The local reference signal may be a short-term stable signal but not necessarily a long-term stable signal. The short-term stability of the local reference signal may be more inaccurate than the short-term stability of the main clock signal. Furthermore, the plurality of first and second frequency values of the main clock signal may comprise first and second frequency values measured at different time instants.

The method may comprise comparing the measured plurality of first frequency values of the main clock signal and comparing the measured plurality of second frequency values of the main clock signal. The method may also comprise determining a relative long-term frequency change between the main clock signal and the external time signal based on the comparison of the measured plurality of first frequency values of the main clock signal. The method may further comprise determining whether a relative frequency change exists between the main clock signal and the local reference signal based on the comparison of the measured plurality of second frequency values of the main clock signal. According to the disclosure, the method may determine the relative long-term frequency change between the main clock signal and the network-based time signal by comparing the first frequency values measured at different time instants. The method may also determine whether the relative frequency change exists between the main clock signal and the local reference signal provided by the crystal oscillator by comparing the second frequency values measure at different time instants.

Configured as above, relative frequency changes between the main clock signal and the local reference signal and relative long-term frequency changes between the main clock signal and the external time signal can be accurately measured.

Small frequency drifts can thus be detected for further frequency supervision without applying a highly-precise superior grade instance. Since the function of a highly-precise superior grade instance may be replaced by joint exploitation of the external time signal and the local reference signal, the cost and complexity for operating the digital system can be significantly reduced according to the solution proposed by the present application. For example, equipment can properly operate without connecting to a highly-precise superior grade instance, which may also improve its operation flexibility.

The method may further include supervising/controlling the main clock signal based on the results of determining a relative long-term frequency change and determining whether a relative frequency change exists. For example, if a relative long-term frequency change exceeds a threshold, a frequency drift of the main clock signal may be determined, implying that the oscillator which provides the main clock signal may have lost stability, and an alarm may be raised accordingly to cause a switch to another oscillator.

According to the disclosure, the method may further comprise measuring a plurality of third frequency values of the main clock signal based on a second external time signal. The method may also comprise measuring a plurality of fourth frequency values of the main clock signal based on a second main clock signal. More specifically, measuring the third frequency values of the main clock signal based on the second external time signal may comprise taking the second external time signal as reference, and the measured third frequency values of the main clock signal may be related to the frequency difference between the main clock signal and the second external time signal, i.e. the measured frequency drift in the third frequency values of the main clock signal may depend on the frequency drift of the second external time signal. Similarly, measuring the fourth frequency values of the main clock signal based on the second main clock signal may comprise taking the second main clock signal as reference, and the measured fourth frequency values of the main clock signal may be related to the frequency difference between the main clock signal and the second main clock signal, i.e. the measured frequency drift in the fourth frequency values of the main clock signal may depend on the frequency drift of the second main clock signal. According to the present application, the second external time signal may be configured to provide time of day information with long-term stability. The second external time signal may be a long-term stable signal but not necessarily a short-term stable signal. The second external time signal may comprise a network-based time signal with long-term stability which may be provided according to a Network Timing Protocol (NTP). According to the present application, the second main clock signal may be provided by a crystal oscillator with short-term stability. The second main clock signal may be a short-term stable signal but not necessarily a long-term stable signal. Furthermore, the plurality of third and fourth frequency values of the main clock signal may comprise third and fourth frequency values measured at different time instants.

According to the disclosure, the measured plurality of third frequency values of the main clock signal may be compared and the measured plurality of fourth frequency values of the main clock signal may also be compared. The method may further comprise determining an absolute long-term frequency change of the main clock signal by comparing the plurality of first frequency values of the main clock signal and comparing the plurality of third frequency values of the main clock signal. More specifically, the method may determine the absolute long-term frequency change of the main clock signal by comparing the first frequency values measured at different time instants, i.e. comparing a first frequency value measured at a time instant with another first frequency value measured at another time instant. The method may determine the absolute long-term frequency change of the main clock signal by also comparing the third frequency values measured at different time instants, i.e. comparing a third frequency value measured at a time instant with another third frequency value measured at another time instant. The method may further comprise determining an absolute frequency change of the main clock signal by comparing the plurality of second frequency values of the main clock signal and comparing the plurality of fourth frequency values of the main clock signal. The method may also determine the absolute frequency change of the main clock signal by comparing the second frequency values measured at different time instants and comparing the fourth frequency values measured at different time instants. That is, the method may determine the absolute frequency change by comparing a second frequency value measured at a time instant with another second frequency value measured at another time instant and comparing a fourth frequency value measured at a time instant with another fourth frequency value measured at another time instant.

Further according to the disclosure, the method may comprise storing the plurality of first frequency values, the plurality of second frequency values, the plurality of third frequency values and the plurality of fourth frequency values of the main clock signal. In other words, the plurality of first frequency values, the plurality of second frequency values, the plurality of third frequency values and the plurality of fourth frequency values of the main clock signal may be stored in a history log for providing the respective measured frequency values at different time instants. According to the disclosure, the plurality of first frequency values may comprise a current first frequency value and a previous first frequency value measured at a previous time instant. Similarly, the plurality of second frequency values may comprise a current second frequency value and a previously measured second frequency value, the plurality of third frequency values may comprise a current third frequency value and a previously measured third frequency value and the plurality of fourth frequency values may comprise a current fourth frequency value and a previously measured fourth frequency value.

The plurality of second frequency values of the main clock signal may comprise a current second frequency value and a plurality of previous second frequency values. The plurality of fourth frequency values of the main clock signal may comprise a current fourth frequency value and a plurality of previous fourth frequency values. The method may further comprise determining a relative short-term frequency change between the main clock signal and the local reference signal based on the comparison of the current second frequency value with the plurality of previous second frequency values of the main clock signal. Similarly, the method may further comprise determining an absolute short-term frequency change of the main clock signal by comparing the current second frequency value with the plurality of previous second frequency values of the main clock signal and comparing the current fourth frequency value with the plurality of previous fourth frequency values of the main clock signal.

The method may further include supervising/controlling the main clock signal based on the results of determining a relative short-term frequency change and determining an absolute short-term frequency change thereof. For example, if a relative short-term frequency change and/or an absolute short-term frequency change exceed(s) a threshold, a frequency drift of the main clock signal may be determined, implying that the oscillator which provides the main clock signal may have lost stability, and an alarm may be raised accordingly to cause a switch to another oscillator.

Configured as above, by combining the functions of the external time signal and the local reference signal, accurate frequency measurements of the main clock signal such as relative long-term and short-term frequency changes and absolute long-term and short-term frequency changes can be easily achieved, thereby enabling reliable frequency supervision without employing a highly-precise superior grade instance, which improves flexibility for operating the digital system with reduced cost and complexity.

According to the present application, measuring the plurality of first frequency values of the main clock signal may comprise reading a time of day via a network, reading a counting content, saving the time of day and calculating a frequency value of the main clock signal based on the counting content and the saved time of day. The time of day may be used to determine a time interval and the counting content may comprise a counted number of cycles of the main clock signal counted during the time interval. The main clock signal may be provided by an Oven Controlled Crystal Oscillator (OCXO). Furthermore, measuring the plurality of first frequency values of the main clock signal may comprise filtering the plurality of first frequency values of the main clock signal. Similarly, measuring the plurality of third frequency values of the main clock signal may comprise filtering the plurality of third frequency values of the main clock signal. Filtering the plurality of first frequency values and the plurality of third frequency values of the main clock signal may comprise averaging the measured first and third frequency values or averaging the deviation of the measured first and third frequency values by applying, for example, a sliding filter. In order to overcome the delay associated with filtering, the previous first frequency value and the previous third frequency value may be preferably obtained at the end of a previous filter response time, and the current first frequency value and the current third frequency value may be preferably obtained at the end of a current filter response time.

Configured as above, by filtering the plurality of first frequency values and the plurality of third frequency values of the main clock signal, the accuracy of frequency measurements can be improved in spite of fluctuations in the external time signal. As such, small frequency drifts of the main clock signal, e.g. relative long-term and short-term frequency changes and absolute long-term and short-term frequency changes, can be accurately detected so that the frequency of the main clock signal can be properly supervised without employing a highly-precise superior grade instance. The method proposed by the present application therefore provides enhanced flexibility for operating equipment with reduced cost and complexity.

Another aspect of the disclosure relates to a frequency supervision apparatus. The apparatus may comprise a first frequency measurement section configured to repeatedly measure a first frequency value of the main clock signal based on an external time signal, a second frequency measurement section configured to repeatedly measure a second frequency value of the main clock signal based on a local reference signal and a frequency supervision section configured to determine a relative long-term frequency change between the main clock signal and the external time signal. More specifically, to measure the first frequency values of the main clock signal based on the external time signal may comprise taking the external time signal as reference, and the measured first frequency values of the main clock signal may be related to the frequency difference between the main clock signal and the external time signal. Similarly, to measure the second frequency values of the main clock signal based on the local reference signal may comprise taking the local reference signal as reference, and the measured second frequency values of the main clock signal may be related to the frequency difference between the main clock signal and the local reference signal. The frequency supervision section may also be configured to determine a relative frequency change between the main clock signal and the local reference signal. The frequency supervision section may determine the relative long-term frequency change and the relative frequency change by comparing the measured first frequency values of the main clock signal and comparing the measured second frequency values of the main clock signal, respectively. The frequency supervision section may further supervise/control the main clock signal based on the results of determining a relative long-term frequency change and a relative frequency change. For example, if a relative long-term frequency change exceeds a threshold, a frequency drift of the main clock signal may be determined, implying that the oscillator which provides the main clock signal may have lost stability, and an alarm may be raised accordingly to cause a switch to another clock signal.

Furthermore, the first frequency measurement section may comprise a time-base unit, a counter section and a processing unit. The time-base unit may be configured to receive the external time signal via a network, e.g. a communications network, and the counter section may comprise a counting unit configured to receive the main clock signal and to count a number of cycles of the main clock signal during a time interval. The counting unit may comprise e.g. a counter which may be typically implemented in hardware. The time interval may be determined based on the received external time signal. The processing unit may be configured to calculate the first frequency value of the main clock signal based on the counted number of cycles of the main clock signal and the time interval. The processing unit may comprise, for example, but not limited to, central processing unit (CPU), network processor, digital signal processor (DSP), etc., which are capable of executing software.

Configured as above, by combining the functions of the first frequency measurement section and the second frequency measurement section, relative frequency changes between the main clock signal and the local reference signal and relative long-term frequency changes between the main clock signal and the external time signal can be accurately measured, which allows detection of small frequency drifts without applying a highly-precise superior grade instance. As such, the apparatus disclosed by the present application significantly reduces the cost and complexity for operating a digital system, e.g. transmission equipment which requires a highly-stable and precise internal clock signal, and further enables more flexible operation thereof.

According to the disclosure, the counter section of the first frequency measurement section may further comprise a memory configured to save a content of the counting unit associated with the counted number of cycles of the main clock signal upon receiving a pulse signal. The counter section may be configured to transfer the content of the counting unit to the memory upon receiving the pulse signal and to reset the counting unit upon transferring the content of the counting unit to the memory. According to the disclosure, the external time signal may comprise a network-based time signal providing a time of day (ToD). The network-based time signal may be long-term stable and may be provided according to a Network Timing Protocol (NTP) which is a proposed standard as documented in RFC 5905. The apparatus may also comprise a crystal oscillator configured to provide the local reference signal.

Furthermore, the processing unit of the first frequency measurement section may be configured to send the pulse signal via an interface to the counter section, read the ToD from the time-base unit and save the ToD as a first ToD value. The interface may comprise a General Purpose Input/Output (GPIO) pin which may be connected between the counter section and the processing unit. The processing unit may be further configured to read the content of the counting unit associated with the counted number of cycles of the main clock signal from the memory, save the first ToD value as a second ToD value and calculate the first frequency value of the main clock signal based on the content of the counting unit and a difference between the first ToD and the second ToD value. It is noted that the first ToD value may refer to a current ToD and the second ToD value may refer to a preceding ToD. Accordingly, the difference between the first ToD and the second ToD value may refer to the time interval during which the cycles of the main clock signal are counted.

According to the disclosure, the processing unit may comprise a timer configured to trigger the sending of the pulse signal, the reading of the ToD and the saving of the ToD as the first ToD value. According to the disclosure, the processing unit may be configured to process a plurality of tasks and may send the pulse signal via the interface to the counter section, read the ToD from the time-base unit and save the ToD as the first ToD value by a high-priority task or process. Moreover, the processing unit may read the content of the counting unit, save the first ToD value as the second ToD value and calculate the first frequency value of the main clock signal by a low-priority task or process. The tasks may be scheduled for operation on the processing unit according to their respective priorities by an operating system. It is noted that the high-priority task may comprise one or more time-critical instructions and may be accomplished during a very short time. It is also noted that the low-priority task may comprise one or more complex and/or time-uncritical instructions. It is further noted that the counter section may be implemented in hardware domain, while the time-base unit and the processing unit may be implemented in software domain.

Configured as above, by dividing the plurality of tasks to be processed by the processing unit into high- and low-priority tasks, accurate frequency measurements based on a network-based time signal can be efficiently achieved, thereby allowing to precisely detect small frequency drifts of the main clock signal without employing a highly-precise superior grade instance. The apparatus proposed by the present application therefore enables reliable frequency supervision of the main clock signal with reduced cost and complexity.

According to the disclosure, the apparatus may further comprise a third frequency measurement section configured to repeatedly measure a third frequency value of the main clock signal based on a second external time signal. The apparatus may also comprise a fourth frequency measurement section configured to repeatedly measure a fourth frequency value of the main clock signal based on a second main clock signal. More specifically, to measure the third frequency values of the main clock signal based on the second external time signal may comprise taking the second external time signal as reference, and the measured third frequency values of the main clock signal may be related to the frequency difference between the main clock signal and the second external time signal. Similarly, to measure the fourth frequency values of the main clock signal based on the second main clock signal may comprise taking the second main clock signal as reference, and the measured fourth frequency values of the main clock signal may be related to the frequency difference between the main clock signal and the second main clock signal. According to the disclosure, the second external time signal may comprise a network-based time signal providing a time of day (ToD). The network-based time signal may be long-term stable and may be provided according to a Network Timing Protocol (NTP). The main clock signal may be provided by an Oven Controlled Crystal Oscillator (OCXO). The second main clock signal may also be provided by OCXO. Further, the third frequency measurement section may comprise one or more elements which may be similar to, for example, the time-base unit, the counter section and the processing unit of the first frequency measurement section.

The apparatus may further comprise a filtering unit configured to filter the measured first frequency values and the measured third frequency values of the main clock signal. According to the disclosure, the measured first frequency values, the measured second frequency values, the measured third frequency values and the measured fourth frequency values may be stored in a history log. With all the measured frequency values available, the frequency supervision section may then determine whether the frequency of the main clock signal is erratic by comparing a previously stored second frequency value and a previously stored fourth frequency value with a current second frequency value and a current fourth frequency value. The frequency supervision section may also determine a short-term frequency change of the main clock signal by comparing at least two previously stored second frequency values and at least two previously stored fourth frequency values with a current second frequency value and a currentfourth frequency value. Furthermore, the frequency supervision section may determine a long-term frequency change of the main clock signal by comparing a previously stored first frequency value and a previously stored third frequency value with a current first frequency value and a current third frequency value. It should also be noted that the previously stored first frequency value and the previously stored third frequency value may be preferably obtained at the end of a previous filter response time of the filtering unit. The current first frequency value and the current third frequency value may be preferably obtained at the end of a current filter response time of the filtering unit.

Configured as above, accurate frequency measurements and frequency drift detection of the main clock signal such as relative long-term and short-term frequency changes and absolute long-term and short-term frequency changes can be easily achieved, thereby enabling reliable frequency supervision without employing a highly-precise superior grade instance, which improves flexibility for operating a digital system with reduced cost and complexity.

Another aspect of the disclosure relates to a frequency supervision method in a clock-redundancy system. The clock-redundancy system may comprise a plurality of oscillator sources and may switch clock operation between the oscillator sources. The clock-redundancy system may be configured to receive a main clock signal from an oscillator source and to receive a second main clock signal from a second oscillator source. The frequency supervision method may comprise measuring a plurality of first frequency values of the main clock signal based on an external time signal, measuring a plurality of second frequency values of the main clock signal based on a local reference signal, measuring a plurality of third frequency values of the main clock signal based on a second external time signal and measuring a plurality of fourth frequency values of the main clock signal based on the second main clock signal. More specifically, measuring the first frequency values of the main clock signal based on the external time signal may comprise taking the external time signal as reference, and the measured first frequency values of the main clock signal may be related to the frequency difference between the main clock signal and the external time signal. Similarly, measuring the second frequency values of the main clock signal based on the local reference signal may comprise taking the local reference signal as reference, and the measured second frequency values of the main clock signal may be related to the frequency difference between the main clock signal and the local reference signal. As mentioned above, measuring the third frequency values of the main clock signal based on the second external time signal may comprise taking the second external time signal as reference, and the measured third frequency values of the main clock signal may be related to the frequency difference between the main clock signal and the second external time signal. Measuring the fourth frequency values of the main clock signal based on the second main clock signal may comprise taking the second main clock signal as reference, and the measured fourth frequency values of the main clock signal may be related to the frequency difference between the main clock signal and the second main clock signal. Moreover, the method may comprise determining a long-term frequency change of the main clock signal based on the measured plurality of first frequency values of the main clock signal and the measured plurality of third frequency values of the main clock signal. The method may further comprise determining a frequency change and a short-term frequency change of the main clock signal based on the measured plurality of second frequency values of the main clock signal and the measured plurality of fourth frequency values of the main clock signal.

The frequency supervision method may further include supervising/controlling the main clock signal based on the results of determining a long-term frequency change of the main clock signal and determining a frequency change and a short-term frequency change of the main clock signal. For example, if a long-term frequency change and/or a short-term frequency change exceed(s) a threshold, a frequency drift of the main clock signal may be determined, implying that the oscillator source may have lost stability, and an alarm may be raised accordingly to cause a switch to the second oscillator source. The method may also determine a frequency drift of the second main clock signal. Similarly, when determining that the second oscillator source may have lost stability, an alarm may be raised accordingly to cause a switch to the oscillator source.

According to the disclosure, the local reference signal may be provided by a crystal oscillator with short-term stability and the external time signal and/or the second external time signal may be configured to provide time of day information with long-term stability. In particular, the external time signal and/or the second external time signal may comprise a network-based time signal with long-term stability. For example, the network-based time signal may be provided according to a Network Timing Protocol (NTP). Furthermore, the oscillator source and/or the second oscillator source may be provided by an Oven Controlled Crystal Oscillator (OCXO).

Further according to the disclosure, measuring the plurality of first frequency values and the plurality of third frequency values of the main clock signal may comprise reading a time of day via a network, reading a counting content, saving the time of day and calculating a frequency value of the main clock signal based on the counting content and the saved time of day. Moreover, measuring the plurality of first frequency values and the plurality of third frequency values of the main clock signal may comprise filtering the plurality of first frequency values and the plurality of third frequency values of the main clock signal.

The method may further comprise storing the measured plurality of first frequency values, the measured plurality of second frequency values, the measured plurality of third frequency values and the measured plurality of fourth frequency values of the main clock signal in a history log. Accordingly, the stored plurality of first frequency values, the stored plurality of second frequency values, the stored plurality of third frequency values and the stored plurality of fourth frequency values of the main clock signal may comprise current and previously stored first frequency values, current and previously stored second frequency values, current and previously stored third frequency values and current and previously stored fourth frequency values of the main clock signal.

Configured as above, by combining the functions of the external time signal, the local reference signal, the second external time signal and the second main clock signal which exist in the clock-redundancy system, accurate frequency measurements of the main clock signal can be easily achieved to enable reliable frequency supervision without employing a highly-precise superior grade instance, which improves flexibility for operating the digital system with reduced cost and complexity. The accuracy of frequency measurements can be improved by filtering the plurality of first frequency values and the plurality of third frequency values of the main clock signal in spite of fluctuations in the external time signal, thereby enabling precise detection of small frequency drifts in the main clock signal so that frequency of the main clock signal can be properly supervised without employing a highly-precise superior grade instance.

It will be appreciated that method steps and device features may be interchanged in many ways. In particular, the details of the disclosed device can be implemented as a method, as the skilled person will appreciate.

## Brief Description of the Figures

Embodiments of the disclosure are explained below in an exemplary manner with reference to the accompanying drawings, wherein

**Fig. 1** schematically illustrates a conventional clock-redundancy configuration;

**Fig. 2** schematically illustrates a frequency supervision apparatus **200** according to embodiments of the disclosure;

**Fig. 3** illustrates processing steps of the frequency supervision apparatus **200** according to embodiments of the disclosure;

**Fig. 4** schematically illustrates a frequency supervision apparatus **400** according to embodiments of the disclosure;

**Fig. 5** schematically illustrates a frequency measurement section **500** which may be applied in the frequency supervision apparatus **200, 400** according to embodiments of the disclosure;

**Fig. 6** schematically illustrates an example of a Network Management system **600;**

**Fig. 7** schematically illustrates the operation of a frequency measurement section divided between software and hardware domain according to embodiments of the disclosure;

**Fig. 8** schematically illustrates a frequency measurement section **800** according to embodiments of the disclosure;

**Fig. 9** schematically illustrates an example of signal diagrams that depicts the operation of the frequency measurement section **800** according to embodiments of the disclosure;

**Fig. 10** schematically illustrates an example of calculation for frequency stabilization through a sliding-window filter according to embodiments of the disclosure; and

**Fig. 11** schematically illustrates measured frequency of the main clock signal over time according to embodiments of the disclosure.

## Detailed Description

The basic idea in this disclosure comprises substituting a highly precise and stable superior grade instance by a combination of a simple external time signal and a cheap local reference signal for frequency supervision of a clock signal as well as realizing accurate frequency measurements of the clock signal despite any inherent inaccuracy caused by internal components. The proposed method and apparatus give a specific solution for problems regarding frequency measurement and supervision, for example for a crystal oscillator supervision.

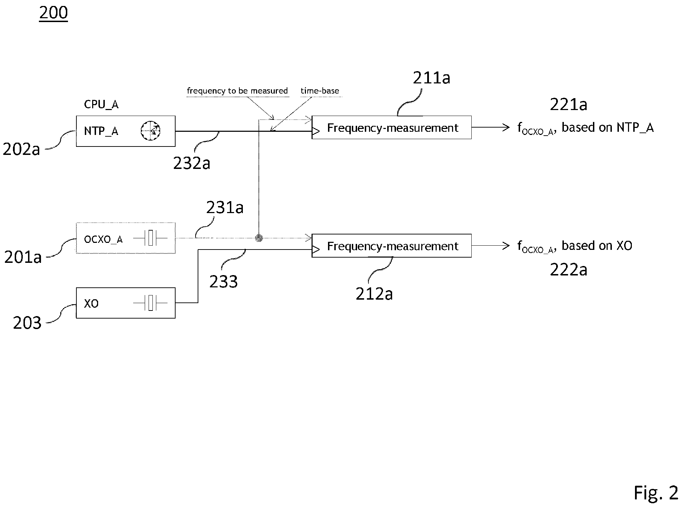

**Fig. 2** is a schematic illustration of a frequency supervision apparatus **200** according to embodiments of the disclosure. The frequency supervision apparatus **200** is configured to measure and monitor a frequency of a main clock signal **231a** and comprises a first frequency measurement section **211a** and a second frequency measurement section **212a.** The first frequency measurement section **211a** receives the main clock signal **231a** from an oscillator source **201a** and receives from an external time source **202a** an external time signal **232a** which serves as a time base for the first frequency measurement section **211a**. The first frequency measurement section **211a** repeatedly measures a first frequency value **221a** of the main clock signal **231a** based on the external time signal **232a**. As mentioned above, measuring the first frequency values **221a** of the main clock signal **231a** "based on" the external time signal **232a** means to take the external time signal **232a** as reference, and the measured first frequency values of the main clock signal may be related to the frequency difference between the main clock signal **231a** and the external time signal **232a**. According to some embodiments, the oscillator source **201a** comprises an Oven Controlled Crystal Oscillator (OCXO) and the main clock signal **231a** is provided by the OCXO. In some embodiments, the oscillator source **201a** comprises other types of crystal oscillator such as temperature-compensated crystal oscillator (TCXO) or other types of oscillators such as circuit oscillators. In general, the main clock signal **231a** can be generated by any type of oscillator to have a level varying repeatedly between a high and a low state which results in one or more cycles.

Further, it is noted that the external time signal **232a** is provided to carry time information such as a time of day (ToD). In some embodiments, the external time signal **232a** comprises a network-based time signal which may be provided according to, for example, but not limited to, a Network Timing Protocol (NTP). In some embodiments, the external time signal **232a** may also be provided according to other clock synchronization protocols such as Precision Time Protocol. Other clock synchronization methods including a radio clock signal in the Global Positioning System may also be used for providing the external time signal **232a** which carries time information. It should be noted that the external time signal **232a** is long-term stable but not necessarily short-term unstable.

The second frequency measurement section **212a** receives the main clock signal **231a** from the oscillator source **201a** and receives from a local reference source **203** a local reference signal **233** which serves as a time base for the second frequency measurement section **212a**. The second frequency measurement section **212a** repeatedly measures a second frequency value **222a** of the main clock signal **231a** based on the local reference signal **233**. As mentioned above, measuring the second frequency values **222a** of the main clock signal **231a** "based on" the local reference signal **233** means to take the local reference signal **233** as reference, and the measured second frequency values of the main clock signal may be related to the frequency difference between the main clock signal **231a** and the local reference signal **233**. In some embodiments, the local reference source **203** comprises a crystal oscillator and the local reference signal **233** is generated by the crystal oscillator. It is noted that the local reference signal **233** is short-term stable but needs not to be long-term stable, and it is therefore sufficient to simply apply a cheap crystal oscillator for the local reference source **203**.

The frequency supervision apparatus **200** further comprises a frequency supervision section (not shown) to monitor frequency drifts of the main clock signal **231a**. In particular, after the first frequency measurement section **211a** and the second frequency measurement section **212a** have measured the first frequency values **221a** and the second frequency values **222a** of the main clock signal **231a**, the frequency supervision section determines a relative long-term frequency change between the main clock signal **231a** and the external time signal **232a**. The frequency supervision section also determines a relative frequency change between the main clock signal **231a** and the local reference signal **233**. The relative long-term frequency change between the main clock signal **231a** and the external time signal **232a** is determined by comparing the measured first frequency values **221a** of the main clock signal. The relative frequency change between the main clock signal **231a** and the local reference signal **233** is determined by comparing the measured second frequency values **222a** of the main clock signal.

For example, the measured first frequency values **221a** and the measured second frequency values **222a** of the main clock signal are stored in a history log file containing all or part of the measured frequency results measured at different time instants. The measured frequency values may also be stored in a file of other types or be stored in other forms. According to the stored measured frequency results, frequency changes/drifts of the main clock signal **231a** can be monitored by analyzing a current frequency value, i.e. $f[n]$, and one or more previously stored frequency values, i.e. $f[n-1]$, $f[n-2]$, ..., $f[n-k]$. That is, the measured first frequency values **221a** comprises at least a current first frequency value and a previous first frequency value measured at a previous time instant. The measured second frequency values **222a** of the main clock signal comprises a current second frequency value and a plurality of previous second frequency values measured at previous time instants, depending on how many frequency samples are to be considered. In some embodiments, determining a relative long-term frequency change between the main clock signal **231a** and the external time signal **232a** is based on the comparison of a current first frequency value with a previous first frequency value of the main clock signal **231a**. In some embodiments, determining a relative short-term frequency change between the main clock signal **231a** and the local reference signal **233** is based on the comparison of a current second frequency value with a plurality of previous second frequency values of the main clock signal **231a**. In some embodiments, determining whether a relative frequency change exists between the main clock signal **231a** and the local reference signal **233** is based on the comparison of a current second frequency value with a plurality of previous second frequency values of the main clock signal **231a**.

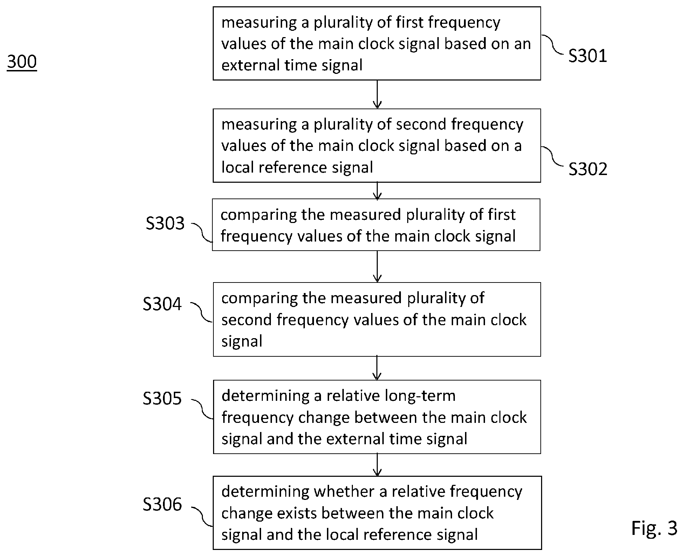

**Fig. 3** schematically illustrates corresponding processing steps of the frequency supervision apparatus **200** according to embodiments of the disclosure. Method **300** comprises measuring, by the first frequency measurement section **211a,** a plurality of first frequency values **221a** of the main clock signal based on an external time signal (step **S301**) and measuring, by the second frequency measurement section **212a,** a plurality of second frequency values **222a** of the main clock signal based on a local reference signal (step **S302**). Also, the method **300** comprises comparing the measured plurality of first frequency values of the main clock signal (step **S303**) and comparing the measured plurality of second frequency values of the main clock signal (step **S304**). The method **300** further comprises determining, by the frequency supervision section, a relative long-term frequency change between the main clock signal and the external time signal based on the comparison of the measured plurality of first frequency values **221a** of the main clock signal (step **S305**) and determining, by the frequency supervision section, whether a relative frequency change exists between the main clock signal and the local reference signal based on the comparison of the measured plurality of second frequency values **222a** of the main clock signal (step **S306**).

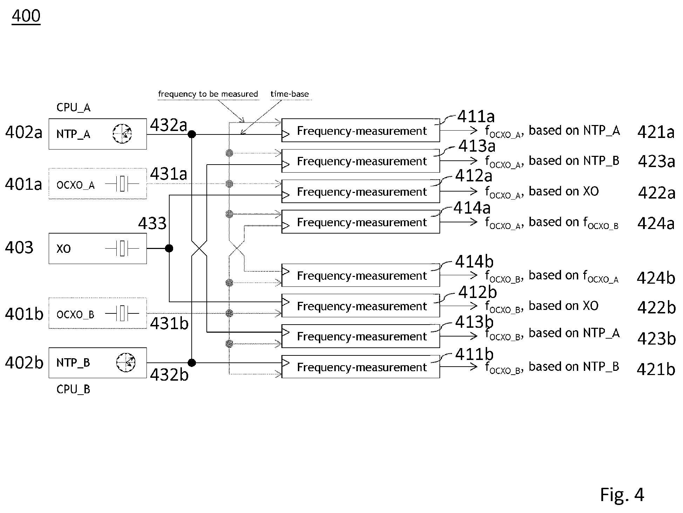

A similar concept may also be applicable to a clock-redundancy system. **Fig. 4** is a schematic illustration of a frequency supervision apparatus **400** according to embodiments of the disclosure. Similar to the frequency supervision apparatus **200,** the frequency supervision apparatus **400** is configured to measure and monitor a frequency of a main clock signal **431a** and comprises a first frequency measurement section **411a** and a second frequency measurement section **412a.** The first frequency measurement section **411a** receives the main clock signal **431a** from an oscillator source **401a** and receives from an external time source **402a** an external time signal **432a** which serves as a time base for the first frequency measurement section **411a.** The first frequency measurement section **411a** repeatedly measures a first frequency value **421a** of the main clock signal **431a** based on the external time signal **432a.** That is, measuring the first frequency values **421a** of the main clock signal **431a** "based on" the external time signal **432a** means to take the external time signal **432a** as reference, and the measured first frequency values of the main clock signal may be related to the frequency difference between the main clock signal **431a** and the external time signal **432a.** The second frequency measurement section **412a** receives the main clock signal **431a** from the oscillator source **401a** and receives from a local reference source **403** a local reference signal **433** which serves as a time base for the second frequency measurement section **412a.** The second frequency measurement section **412a** repeatedly measures a second frequency value **422a** of the main clock signal **431a** based on the local reference signal **433.** As mentioned above, measuring the second frequency values **422a** of the main clock signal **431a** "based on" the local reference signal **433** means to take the local reference signal **433** as reference, and the measured second frequency values of the main clock signal may be related to the frequency difference between the main clock signal **431a** and the local reference signal **433.**

Since the frequency supervision apparatus **400** operates in a clock-redundancy configuration, it comprises a second oscillator source **401b** providing a second main clock signal **431b.** Due to the required redundancy, each oscillator source/signal is supervised by four frequency measurements. Accordingly, the frequency supervision apparatus **400** further comprises a third frequency measurement section **413a** configured to repeatedly measure a third frequency value **423a** of the main clock signal based on a second external time signal **432b.** As mentioned above, measuring the third frequency values **423a** of the main clock signal **431a** "based on" the second external time signal means to take the second external time signal **432b** as reference, and the measured third frequency values of the main clock signal may be related to the frequency difference between the main clock signal **431a** and the second external time signal **432b.** As depicted in **Fig. 4,** the third frequency measurement section **413a** receives the main clock signal **431a** from the oscillator source **401a** and receives from a second external time source **402b** the second external time signal **432b** which serves as a time base for the third frequency measurement section **413a.** The frequency supervision apparatus **400** further comprises a fourth frequency measurement section **414a** configured to repeatedly measure a fourth frequency value **424a** of the main clock signal based on the second main clock signal **431b.** Measuring the fourth frequency values **424a** of the main clock signal **431a** "based on" the second main clock signal **431b** means to take the second main clock signal **431b** as reference, and the measured fourth frequency values of the main clock signal may be related to the frequency difference between the main clock signal **431a** and the second main clock signal **431b.** The fourth frequency measurement section **414a** receives the main clock signal **431a** from the oscillator source **401a** and receives from the second oscillator source **401b** the second main clock signal **431b** which serves as a time base for the fourth frequency measurement section **414a.** In some embodiments, the frequency supervision apparatus **400** may further comprise another four frequency measurement sections **411b, 412b, 413b, 414b** for measuring and monitoring a frequency of the second main clock signal **431b.** By applying the frequency supervision apparatus **400** operating in a clock-redundancy configuration, eight measured frequency values **421a, 422a, 423a, 424a, 421b, 422b, 423b, 424b** are obtained at a certain time instant.

Further, it is noted that the external time signal **432a** and the second external time signal **432b** are provided to carry time information such as a time of day (ToD). In some embodiments, the external time signal **432a** and/or the second external time signal **432b** comprise(s) a network-based time signal which may be provided according to, for example, but not limited to, a Network Timing Protocol (NTP). In some embodiments, the external time signal **432a** and/or the second external time signal **432b** may also be provided according to other clock synchronization protocols such as Precision Time Protocol. Other clock synchronization methods including a radio clock signal in the Global Positioning System may also be used for providing the external time signal **432a** and/or the second external time signal **432b** which carries time information. It should be noted that the external time signal **432a** and the second external time signal **432b** are long-term stable but typically short-term unstable.

According to some embodiments, the oscillator source **401a** and/or the second oscillator source **401b** comprise(s) an OCXO and thus the main clock signal **431a** and/or the second main clock signal **431b** is provided by the OCXO. In some embodiments, the oscillator source **401a** and/or the second oscillator source **401b** comprise(s) other types of crystal oscillator such as TCXO or other types of oscillators such as circuit oscillators. In general, the main clock signal **431a** and the second main clock signal **431b** can be generated by any type of oscillator to have a level varying repeatedly between a high and a low state which results in one or more cycles.

According to some embodiments, the local reference source **403** comprises a crystal oscillator and the local reference signal **433** is generated by the crystal oscillator. It is noted that the local reference signal **433** is short-term stable but needs not to be long-term stable, and it is therefore sufficient to simply apply a cheap crystal oscillator for the local reference source **403**. For example, in the clock-redundancy configuration, the local reference source **403** may be a separate and non-redundant cheap crystal oscillator (XO). Normally, such a cheap crystal oscillator XO has lower stability compared to OCXO. The typical frequency offset of an OCXO is about +/-2.5 ppm, while the typical frequency offset of a crystal oscillator may reach about +/-50 ppm.

The measured frequency in general has a very large value, as the clock frequency is usually higher than 10MHz. In order to obtain simple and manageable values, the measured frequency values may be converted into frequency offset, i.e. the deviation of the measured frequency focxo from the nominal frequency $f_{nominal}$, by the following equations:

$$f_{OCXO} - f_{nominal} = \Delta f \quad (Hz)$$

$$\frac{\Delta f}{10^{-6} \times f_{nominal}} = \Delta f \quad (ppm)$$

After the conversion, the measured frequency values (e.g. the eight converted results **421a, 422a, 423a, 424a, 421b, 422b, 423b, 424b**) are stored cyclic in a history log file. The measured frequency values may contain the results measured at different time instants. Depending on the number of frequency samples of different time instants which are to be considered, the cyclic time and length of the history log can be defined accordingly. The measured frequency values may also be stored in a file of other types or be stored in other forms.

The frequency supervision apparatus **400** further comprises a frequency supervision section (not shown) to monitor frequency drifts of the main clock signal **431a** and the second main clock signal **431b.** Similar to the embodiments of the frequency supervision apparatus **200,** the frequency supervision section determines a relative long-term frequency change between the main clock signal **431a** and the external time signal **432a** by comparing a current first frequency value with a previous first frequency value of the main clock signal. The frequency supervision section of the frequency supervision apparatus **400** also determines whether a relative frequency change exists between the main clock signal **431a** and the local reference signal **433** by comparing a current second frequency value with a plurality of previous second frequency values of the main clock signal and determines a relative short-term frequency change between the main clock signal **431a** and the local reference signal **433** based on the comparison of a current second frequency value with a plurality of previous second frequency values of the main clock signal **431a.**

The frequency supervision section of the frequency supervision apparatus **400** further determines an absolute long-term frequency change of the main clock signal **431a** by at least comparing the plurality of first frequency values **421a** of the main clock signal, i.e. a current first frequency value and a previous first frequency value measured at a previous time instant, and comparing the plurality of third frequency values **423a** of the main clock signal, i.e. a current third frequency value and a previous third frequency value measured at a previous time instant, for example, by comparing **421a, 423a, 421b, 423b** at the end of previous and at the end of the actual filter response time to get slow/long-term changes of focxo. The frequency supervision section of the frequency supervision apparatus **400** further determines an absolute frequency change of the main clock signal **431a** by at least comparing the plurality of second frequency values **422a** of the main clock signal, i.e. a current second frequency value and a previous second frequency value measured at a previous time instant, and comparing the plurality of fourth frequency values **424a** of the main clock signal, i.e. a current fourth frequency value and a previous fourth frequency value measured at a previous time instant, for example, by comparing **422a, 424a, 422b, 424b** of the previous storage location "n-1" with those of the actual storage location "n" to get erratic changes of focxo. The frequency supervision section of the frequency supervision apparatus **400** further determines an absolute short-term frequency change of the main clock signal **431a** by at least comparing a current second frequency value with a plurality of previous second frequency values of the main clock signal **431a** and comparing a current fourth frequency value with a plurality of previous fourth frequency values of the main clock signal **431a,** for example, by comparing **422a, 424a, 422b, 424b** of many previous storage locations "n-1, n-2, ..., n-k" with those of the actual storage location "n" to get fast/short-term changes of focxo. It is noted that the value of k may be defined based on how many number of frequency samples of different time instants are to be considered for monitoring fast and/or slow frequency changes. For example, for determining fast frequency changes, f[n] may be compared with f[n-1], f[n-2], ..., f[n-m], while for determining slow frequency changes, f[n] may be compared with f[n-t], where |t|>>|m|. For example, t and m may be equal to 100 and 10, respectively.

Detailed analyses for frequency supervision of the main clock signal **431a** according to some embodiments of the present disclosure may be carried out as follows. **Table 1** shows the measured frequency values **422a, 424a, 422b, 424b** of the previous storage location (i.e. at the previous time instant) "n-1" compared with those of the actual storage location (i.e. at the current time instant) "n" for different cases: "no fault" referring to the case when no frequency drifts occur, while "fault #1" and "fault #2" referring to the case when frequency drifts occur. In the embodiments, the measured frequency value **422a** represents the measured frequency $F_{OCXO\_A}$, based on XO, the measured frequency value **424a** represents the measured frequency $F_{OCXO\_A}$, based on $F_{OCXO\_B}$, the measured frequency value **422b** represents the measured frequency $F_{OCXO\_B}$, based on XO, and the measured frequency value **424b** represents the measured frequency $F_{OCXO\_B}$, based on $F_{OCXO\_A}$. These measured frequency values are converted into frequency offset expressed by $\Delta t$ (ppm).

**Table 1.**

| $\Delta f$ (ppm) | no fault | | fault #1 | | fault #2 | |
|---|---|---|---|---|---|---|
| | n-1 | n | n-1 | n | n-1 | n |
| **424a** | +0.5 | +0.5 | +0.5 | +3.6 | +0.5 | +0.5 |
| **424b** | -0.5 | -0.5 | -0.5 | -3.6 | -0.5 | -0.5 |
| **422a** | -3.7 | -3.7 | -3.7 | -0.6 | -3.7 | +7.3 |
| **422b** | -4.2 | -4.2 | -4.2 | -4.2 | -4.2 | +6.8 |

After obtaining the measured frequency values **422a, 424a, 422b, 424b** shown in **Table. 1,** the difference between different time instants n-1 and n of the individual measured frequency values **422a, 424a, 422b, 424b** are compared for determining an erratic change of the measured frequency. For example, in the case of "fault #1":

$\Delta 1$ = difference between n-1 and n of $F_{OCXO\_A}$, based on $F_{OCXO\_B}$ **424a** = +3.1 ppm
$\Delta 2$ = difference between n-1 and n of $F_{OCXO\_B}$, based on $f_{OCXO\_A}$ **424b** = -3.1 ppm
$\Delta 3$ = difference between n-1 and n of $F_{OCXO\_A}$, based on XO **422a** = +3.1 ppm
$\Delta 4$ = difference between n-1 and n of $F_{OCXO\_B}$, based on XO **422b** = 0 ppm

Thus, from $\Delta 1$ and $\Delta 2$, both $f_{OCXO\_A}$ and $F_{OCXO\_B}$ have change of |3.1| ppm, it can be interpreted that either $f_{OCXO\_A}$ or $F_{OCXO\_B}$ is changing. Additionally from $\Delta 3$, it is indicated that a change of +3.1 ppm may occur in either $f_{OCXO\_A}$ or fxo. Since $\Delta 4$=0 ppm implies that no change occurs in both $F_{OCXO\_B}$ and fxo and that $F_{OCXO\_B}$ is thus stable, it is inferred that $f_{OCXO\_A}$ has an erratic change of +3.1 ppm. Similarly for the case of "fault #2" where $\Delta 1$=A2=0, $\Delta 3$=+11 ppm and $\Delta 4$=11 ppm, no change occurs in both $f_{OCXO\_A}$ and $F_{OCXO\_B}$ and both $f_{OCXO\_A}$ and $F_{OCXO\_B}$ are stable. As it is indicated from $\Delta 3$ and $\Delta 4$ there is a frequency change of +11 ppm, it can be inferred that fxo has an erratic change of +11 ppm.

Furthermore, it should be noted that the measured frequency values **422a, 424a, 422b, 424b** for different cases "no fault", "fault #1" and "fault #2" may also be obtained through the following calculations which are enclosed herein for verifying the results of the above analyses for frequency supervision according to the present disclosure.

Assuming $f_{OCXO\_A}$=0.3 ppm, $f_{OCXO\_B}$=-0.2 ppm, $f_{XO}$=4.0 ppm in the case of "no fault":

$$f_{OCXO\_A}, \text{ based on } f_{OCXO\_B} \text{ } 424a = f_{OCXO\_A} - f_{OCXO\_B} = (+0.3) - (-0.2) = +0.5 \text{ ppm}$$

$$f_{OCXO\_B}, \text{ based on } f_{OCXO\_A} \text{ } 424b = f_{OCXO\_B} - f_{OCXO\_A} = (-0.2) - (+0.3) = -0.5 \text{ ppm}$$

$$f_{OCXO\_A}, \text{ based on XO } 422a = f_{OCXO\_A} - f_{XO} = (+0.3) - (+4.0) = -3.7 \text{ ppm}$$

$$f_{OCXO\_B}, \text{ based on XO } 422b = f_{OCXO\_B} - f_{XO} = (-0.2) - (+4.0) = -4.2 \text{ ppm}$$

In the case of "fault #1" where $\underline{f_{OCXO\_A}}=3.4$ ppm, $f_{OCXO\_B}=-0.2$ ppm, $f_{XO}=4.0$ ppm,

$$f_{OCXO\_A}, \text{ based on } f_{OCXO\_B} \text{ } 424a = f_{OCXO\_A} - f_{OCXO\_B} = (\underline{+3.4}) - (-0.2) = +3.6 \text{ ppm}$$

$$f_{OCXO\_B}, \text{ based on } f_{OCXO\_A} \text{ } 424b = f_{OCXO\_B} - f_{OCXO\_A} = (-0.2) - (\underline{+3.4}) = -3.6 \text{ ppm}$$

$$f_{OCXO\_A}, \text{ based on XO } 422a = f_{OCXO\_A} - f_{XO} = (\underline{+3.4}) - (+4.0) = -0.6 \text{ ppm}$$

$$f_{OCXO\_B}, \text{ based on XO } 422b = f_{OCXO\_B} - f_{XO} = (-0.2) - (+4.0) = -4.2 \text{ ppm}$$

In the case of "fault #2" where $f_{OCXO\_A}=0.3$ ppm, $f_{OCXO\_B}=-0.2$ ppm, $\underline{f_{XO}=-7}$ ppm,

$$f_{OCXO\_A}, \text{ based on } f_{OCXO\_B} \text{ } 424a = f_{OCXO\_A} - f_{OCXO\_B} = (+0.3) - (-0.2) = +0.5 \text{ ppm}$$

$$f_{OCXO\_B}, \text{ based on } f_{OCXO\_A} \text{ } 424b = f_{OCXO\_B} - f_{OCXO\_A} = (-0.2) - (+0.3) = -0.5 \text{ ppm}$$

$$f_{OCXO\_A}, \text{ based on XO } 422a = f_{OCXO\_A} - f_{XO} = (+0.3) - (\underline{-7.0}) = +7.3 \text{ ppm}$$

$$f_{OCXO\_B}, \text{ based on XO } 422b = f_{OCXO\_B} - f_{XO} = (-0.2) - (\underline{-7.0}) = +6.8 \text{ ppm}$$

As such, by comparing the measured frequency values **422a, 424a, 422b, 424b** of the previous storage location "n-1" with those of the actual storage location "n", an erratic frequency change can be determined without applying a superior grade instance. It should be noted that not all of the measured frequency values **422a, 424a, 422b, 424b** are needed for the determination depending on different fault cases. In some embodiments, only the measured frequency values **422a, 424a** may be sufficient for the determination. It is thus appreciated that an absolute frequency change of the main clock signal **431a** can be determined by at least comparing a current and a previous second frequency value **422a** of the main clock signal and comparing a current and a previous fourth frequency value **424a** of the main clock signal.

It is further appreciated that the above analyses may also be applicable to the determination of an absolute long-term frequency change of the main clock signal **431a** by at least comparing a current and a previous first frequency value **421a** of the main clock signal and comparing a current and a previous third frequency value **423a** of the main clock signal. Furthermore, the above analyses may also be applicable to the determination of an absolute short-term frequency change of the main clock signal **431a** by at least comparing a current second frequency value with a plurality of previous second frequency values of the main clock signal **431a** and comparing a current fourth frequency value with a plurality of previous fourth frequency values of the main clock signal **431a**. As such, the proposed method and apparatus provide an opportunity to accurately measure the frequency of a clock signal, e.g. a crystal oscillator, and to precisely detect its frequency drifts without a superior grade instance, thereby enabling reliable frequency supervision with reduced cost and complexity.

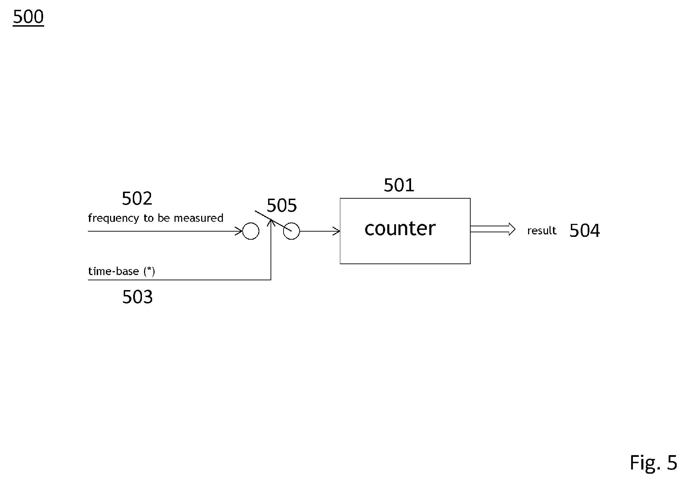

**Fig. 5** schematically illustrates a frequency measurement section **500** which may be applied as one or more of the first and third frequency measurement sections **211a, 411a, 411b, 413a, 413b** in the frequency supervision apparatus **200, 400** for measuring and monitoring a frequency of the main clock signal and/or the second main clock signal **231a, 431a, 431b** according to embodiments of the disclosure. The frequency measurement section **500** comprises a time-base controlled switch **505** and a counter **501**. A time base employed for the frequency measurement section **500** may have a certain voltage/current level which sets the switch **505** to be in an on-state for a period of time to let the main clock signal **502** pass to the counter **501.** Thus, the time base **503** controls the switch **505** so that the counter **501** counts a number of cycles of the main clock signal **502** during a time interval when the switch **505** is on. The counting result **504** is then further divided by the length of the time base, i.e. the time interval during which the switch **505** is on, to obtain the measured frequency of the main clock signal **502.** For example, if the length of the time base is 1 second, the contents of the counter **501** (i.e. the counting result) is the measured frequency (Hz). In the embodiments of the frequency supervision apparatus **200, 400,** the frequency to be measured, i.e. the frequency of the main clock signal **502,** may be OCXO frequency and a network-based time signal providing a stable and filtered time of day (ToD) may be used as the time base **503.** A similar approach may also be employed for implementing the second and fourth frequency measurement sections **212a, 412a, 412b, 414a, 414b** by applying the local reference signal **233, 433** from a local oscillator as the time base.

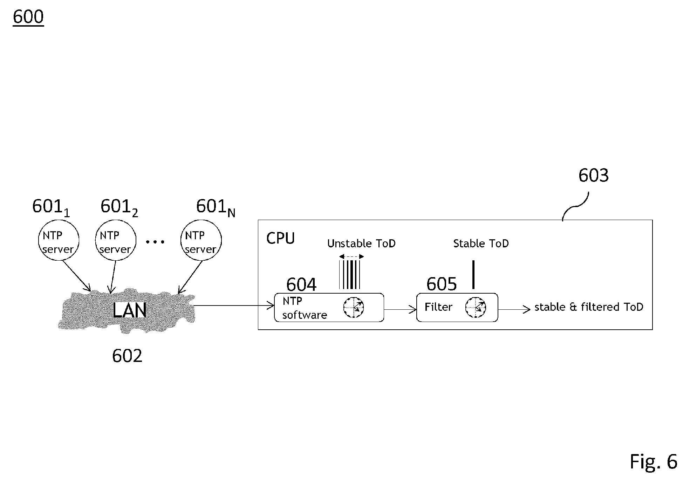

As mentioned above, other clock synchronization protocols or methods may also be used as the time base **503.** It is in particular beneficial to use a network-based time signal providing a ToD as a time base for frequency measurement, as most digital systems, e.g. transmission equipment and many electronic devices, usually include a Central Processing Unit (CPU) and are connected via Local Area Network (LAN) to a Network Management (NM) system. In particular, Network Timing Protocol (NTP) is widely used to have a common ToD (Time of Day) within a network and to timestamp all events such as alarms. **Fig. 6** schematically illustrates an example of a Network Management system **600.** A local digital system, e.g. a PC, transmission equipment, etc., is connected to the NM system **600** via LAN **602** and receives ToD information sent from a plurality of NTP server **601$_1$, 601$_2$, ..., 601$_N$** through the network. The digital system then adjusts its internal clock based on the ToD information by a NTP software **604** to identify the ToD. Since the delay from a selected NTP server to the CPU **603** of the digital system is not a stable value, the delay variation over the LAN **602** and the work load of the CPU **603** may cause an unstable ToD identified by the NTP software **604.** Therefore, it may be necessary to stabilize ToD values by way of filtering **605.**

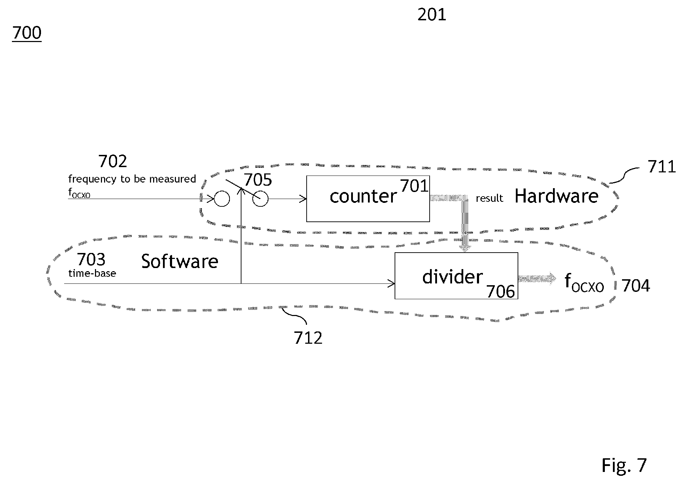

Accordingly, any of the first and third frequency measurement sections **211a, 411a, 411b, 413a, 413b** in the frequency supervision apparatus **200, 400** may be realized by employing a ToD received via a network as a time base for the frequency measurement section **500.** In this way, the operation of the frequency measurement section is divided between software and hardware domain, as illustrated in **Fig. 7,** because the time base **703** is calculated by the software **712** whereas the counter **701** and the switch **705** are realized in hardware **711** and the frequency calculation through a divider **706** (i.e. the counting result divided by the length of the time base) is again implemented by software **712** to get the measured frequency **704** of the main clock signal **702.** However, it is quite difficult to realize this operation via an interface between software and hardware, since the frequency to be measured (e.g. focxo) is usually higher than 10MHz, which required a very high accuracy of the interface between software and hardware (e.g. at least in the nanosecond range).

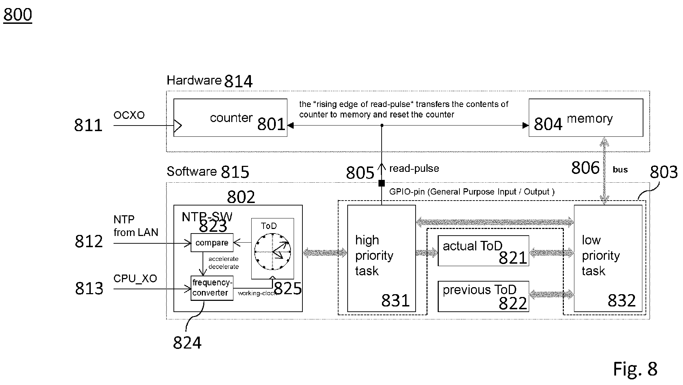

**Fig. 8** is a schematic illustration of a frequency measurement section **800** which may be applied as one or more of the first and third frequency measurement sections **211a, 411a, 411b, 413a, 413b, 500, 700** for measuring and monitoring a frequency of a main clock signal **811** (e.g. focxo) according to embodiments of the disclosure. In some embodiments, the frequency measurement section **800** may be a first frequency measurement section and configured to repeatedly measure a first frequency value of the main clock signal **811** based on an external time signal **812.** The frequency measurement section **800** comprises a time-base unit **802** configured to receive the external time signal **812** via a network. According to some embodiments, the time-base unit **802** may be, for example, a NTP software which comprises a comparing unit **823,** a frequency converting unit **824** and a ToD indicator **825.** The NTP software **802** receives a network-based time signal **812** providing ToD information and compares the ToD information with the result of the ToD indicator **825** which is associated with an internal clock **813.** Through the comparing unit **823** and the frequency converting unit **824** the result of the ToD indicator **825** can be adjusted based on the difference between the ToD information of the network-based time signal **812** and the time information of the internal clock **813.**

The frequency measurement section **800** further comprises a counter section **814** comprising a counting unit **801** configured to receive the main clock signal **811** and to count a number of cycles of the main clock signal during a time interval. The frequency measurement section **800** also comprises a processing unit **803** configured to calculate the first frequency value of the main clock signal based on the counted number of cycles of the main clock signal and the time interval. As mentioned above, the counter section **814** is implemented in hardware domain, while the time-base unit **802** and the processing unit **803** are implemented in software domain **815.** According to some embodiments, the counter section **814** further comprises a memory **804** configured to save a content of the counting unit **801** associated with the counted number of cycles of the main clock signal upon receiving a pulse signal. The processing unit **803** may be divided into two parts based on process tasks, i.e. a high-priority-task section **831** and a low-priority-task section **832.**

A timer of the low-priority-task section **832** may start the high-priority-task section 831 to execute two simple and fast actions of sending a rising edge of a read pulse to an interface **805** between the hardware and software domain, e.g. a General Purpose Input/Output (GPIO) pin, and reading ToD from the NTP software **802** and writing it to "actual ToD" **821.** It is noted that the rising edge of the read pulse transfers the content of the counting unit **801** to the memory **804** and resets the counting unit **801.**

Subsequently, the low-priority-task section **832** may process complex and time-consuming actions of reading the memory via a bus **806,** calculating the difference between "actual ToD" **821** and "previous ToD" **822,** calculating the frequency of the main clock signal focxo which is the result of "contents of memory" divided by "difference" and transferring "actual ToD" **821** to "previous ToD" **822** for the next calculation. The low-priority-task section **832** may further send the falling edge of the read pulse to the interface **805.** It should be noted that the time stored in "actual ToD" **821** is the time when the contents of the counting unit **801** is transferred to memory **804,** which is the simple achievable accuracy requirement and can be easily implemented in any software.

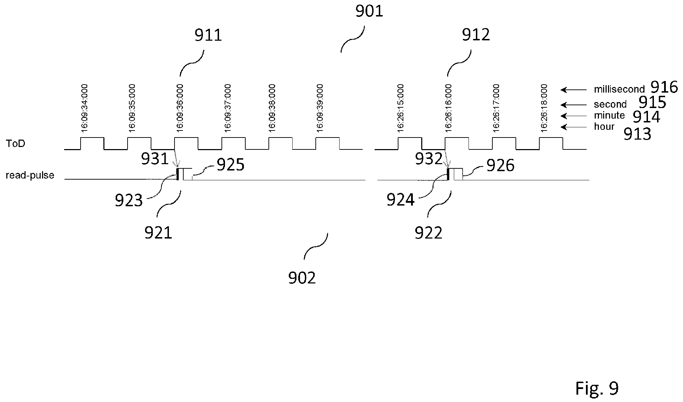

**Fig. 9** shows an example of signal diagrams that depicts the operation of the frequency measurement section **800** according to embodiments of the disclosure. Curve **901** represents a signal of ToD to be read from the NTP software **802** and curve **902** represents a signal of the read pulse sent by the high-priority-task section **831**. The ToD signal **901** comprises time information **911, 912** which may be expressed by, for example, but not limited to hour **913**, minute **914,** second **915** and/or millisecond **916**. The read pulse signal **902** comprises at least two read pulses **921, 922** each of which has a rising edge **923, 924** sent by the high-priority-task section **831** and each of which may further comprise a falling edge **925, 926** sent by the low-priority-task section **832**. In this example, the length of the read pulse, i.e. the period length of the read pulse or the time interval between two read pulses **921, 922,** is 1000 seconds ($\sim$16 minutes 40 seconds), which is however not critical because the result of "contents of memory" divided by "difference" is independent of the period length of the read pulse. It is noted that the difference in time between "sending rising edge of the read pulse to GPIO" and "read ToD from NTP software" should not be changed from read pulse to read pulse, as indicated by the arrows **931, 932**. Nevertheless, a fixed difference is not critical.

It is therefore appreciated that by splitting the software, especially the processing tasks of the processing unit **803,** into two parts consisting of a simple and short but time-critical high-priority part and a complex but time-uncritical low-priority part, the operation of the frequency measurement section **700, 800** divided between software and adequate hardware via the interface can be easily realized. In particular, since the high-priority task is very short, the probability for a break caused by a higher-order interrupt is therefore very low. If, nevertheless, an improbably break happened, the subsequent failure may be eliminated by a successive filter.

As mentioned above, the delay variation in the LAN and the working load of the local CPU causing an unstable ToD may lead to an unstable result of frequency calculation, i.e. $f_{OCXO} = \dfrac{contents\ of\ memory}{difference\ in\ time}$. In order to stabilize the frequency values, focxo may be filtered to obtain a stable average by applying, for example, a usual sliding-window filter. A usual sliding-window filter such as a finite-impulse-response (FIR) filter can perform the average calculation and may also be implemented by the software. Therefore, in some embodiments, the frequency measurement section **700, 800** may further comprise a filtering unit (now shown) to filter the measured first frequency values and the measured third frequency values of the main clock signal.

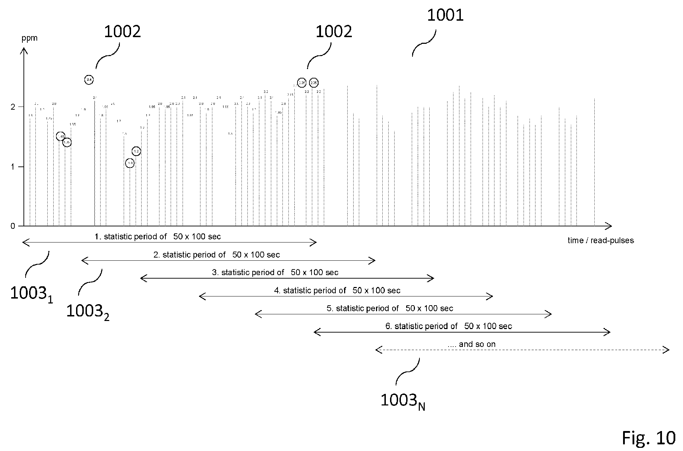

**Fig. 10** shows an example of calculation for frequency stabilization through a sliding-window filter according to embodiments of the disclosure. It is depicted in **Fig. 10** a number of measured frequency values **1001** in ppm which are calculated after sending a corresponding read pulse to hardware, i.e. the counter section **814**. The sliding-window filter averages a number of frequency points received at its input to produce an average frequency value at its output. In other words, all measured frequency values in each statistic period **1003$_1$, 1003$_2$, ..., 1003$_N$** are added for calculating the average frequency value of that statistic period **1003$_1$, 1003$_2$, ..., 1003$_N$.** For example, for averaging the measured frequency values in the first statistic period **1003$_1$** which has a length of 50 read pulses, the first 50 frequency values are taken into account and the first average frequency value is obtained by $\dfrac{1.8+2.0+1.9+\cdots+2.2}{50} = 1.917$ ppm. In some embodiments, the accuracy of the filter may be further improved by removing extreme values, e.g. all values outside +/-20 % **1002** according to Gaussian distribution. In this example, all values which exceed 2.30 ppm (i.e. +20 %) or go below 1.54 ppm (i.e. -20 %) may be removed for the average calculation and the final average calculation may be performed as $\dfrac{83.75}{43} = 1.948$ ppm, where seven points have been removed in the first statistic period. Similar average calculation may be also applied to the measured frequency values in other statistic periods **1003$_2$, ..., 1003$_N$** to obtain a stable measured frequency value. In this example, the period length of a read pule is 100 seconds, the filter response time is 10x100 seconds and the length of a statistic period is 50xread-pulse length=5000 seconds. However, these values in general can be adjusted and are software configurable.

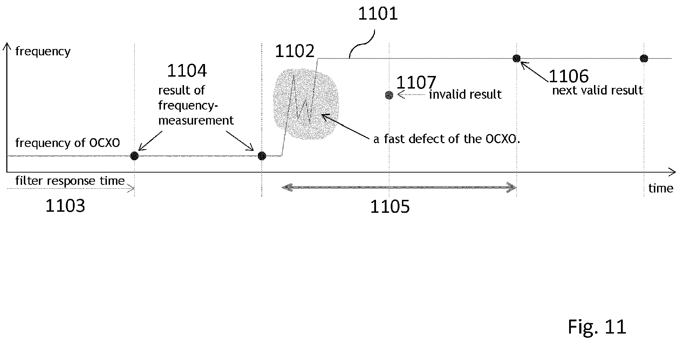

As the filtering process takes some time, i.e. filter response time, during which no valid result of frequency measurement (e.g. the NTP-based frequency measurement) is available, a new result of frequency measurement can only be calculated at the end of a filter response time, which may be associated with a new ToD. In the example of **Fig. 11** which depicts the measured frequency **1101** of the main clock signal over time, only the frequency values **1104, 1106** calculated after the end of a filter response time **1103, 1105** are valid to represent the results of frequency measurement at different time instants, e.g. a current and one or more previous frequency values. It is noted that the frequency value **1107** calculated during the filter response time **1105** is an invalid result due to fast frequency drifts **1102** of the main clock signal. Thus, in order to increase the accuracy of the frequency measurement section **700, 800** for measuring e.g. the first and third frequency values, the previously stored frequency value may be obtained at the end of a previous filter response time of the filtering unit, and the current frequency value may be obtained at the end of a current filter response time of the filtering unit.

Accordingly, such frequency measurement through the frequency measurement section **700, 800** applying a network-based time signal, e.g. the NTP-based frequency measurement, may be used for supervising defects causing slow frequency drifts of the main clock signal which are longer than the filter response time because the network-based time signal is in general long-term stable. Further through a second frequency measurement section and/or a fourth frequency measurement section applying a local reference signal (e.g. a crystal oscillator signal) as time base, defects causing fast frequency drifts of the main clock signal which are shorter than the filter response time can be properly monitored. It should be noted that the second and fourth frequency measurement section does not need a long-term stable time base for measuring fast frequency drifts, because it may substitute the NTP-based frequency measurement only for a length of one or two filter response times. As such, the local reference signal for measuring fast frequency drifts may be provided by a cheap crystal oscillator (XO) with mere short-term stability, and the second and fourth frequency measurement section may be used to realize XO based frequency measurement.

It is therefore appreciated that the proposed method and apparatus enable a precise NTP-based frequency measurement implemented by software in combination with support of adequate hardware, despite the inherent inaccuracy of the software. In particular, a precise focxo measurement can be obtained despite any software inaccuracy based on a time uncritical interface between "NTP software" and "adequate frequency counter hardware". It is further appreciated that the combined use of the Network Timing Protocol (NTP) as time base for slow drift detection and a cheap crystal oscillator for fast drift detection realizes the function of an expensive and highly-precise "superior grade instance".

In other words, the proposed method and apparatus enable precise frequency measurements (e.g. focxo) without a superior grade instant. Precise focxo measurements despite inaccuracy of software allow an accuracy detection of frequency drifts (e.g. OCXO drift), thereby providing an effective solution for crystal oscillator supervision. Furthermore, if a frequency drift exceeds a threshold, e.g. a programmable threshold, an alarm may be raised to the operator to cause an automatic switch to a redundant OCXO.

It should be noted that the apparatus features described above correspond to respective method features that are however not explicitly described, for reasons of conciseness. The disclosure of the present document is considered to extend also to such method features.

It should be further noted that the description and drawings merely illustrate the principles of the proposed device. Those skilled in the art will be able to implement various arrangements that, although not explicitly described or shown herein, embody the principles of the invention and are included within its spirit and scope. Furthermore, all examples and embodiment outlined in the present document are principally intended expressly to be only for explanatory purposes to help the reader in understanding the principles of the proposed device. Furthermore, all statements herein providing principles, aspects, and embodiments of the invention, as well as specific examples thereof, are intended to encompass equivalents thereof.

## Claims

1. Method for supervising a frequency of a main clock signal, comprising:

   measuring a plurality of first frequency values of the main clock signal based on an external time signal;
   measuring a plurality of second frequency values of the main clock signal based on a local reference signal;
   comparing a measured first frequency value with one or more other first frequency values from the plurality of first frequency values of the main clock signal;
   comparing a measured second frequency value with one or more other second frequency values from the plurality of second frequency values of the main clock signal;
   determining a relative long-term frequency change between the main clock signal and the external time signal based on the comparison of the measured first frequency values of the main clock signal; and
   determining whether a relative frequency change exists between the main clock signal and the local reference signal based on the comparison of the measured second frequency values of the main clock signal.

2. The method according to claim 1, further comprising:

measuring a plurality of third frequency values of the main clock signal based on a second external time signal; and

measuring a plurality of fourth frequency values of the main clock signal based on a second main clock signal.

3. The method according to claim 2, further comprising:

determining an absolute long-term frequency change of the main clock signal by comparing a measured first frequency value with one or more other first frequency values from the plurality of first frequency values of the main clock signal and comparing a measured third frequency value with one or more other third frequency values from the plurality of third frequency values of the main clock signal; and/or

determining an absolute frequency change of the main clock signal by comparing a measured second frequency value with one or more other second frequency values from the plurality of second frequency values of the main clock signal and comparing a measured fourth frequency value with one or more other fourth frequency values from the plurality of fourth frequency values of the main clock signal.

4. The method according to claim 2, wherein the plurality of second frequency values of the main clock signal comprises a current second frequency value and a plurality of previous second frequency values, the method further comprising determining a relative short-term frequency change between the main clock signal and the local reference signal based on the comparison of the current second frequency value with one or more of the plurality of previous second frequency values of the main clock signal.

5. The method according to claim 4, wherein the plurality of fourth frequency values of the main clock signal comprises a current fourth frequency value and a plurality of previous fourth frequency values, the method further comprising determining an absolute short-term frequency change of the main clock signal by comparing the current second frequency value with one or more of the plurality of previous second frequency values of the main clock signal and comparing the current fourth frequency value with one or more of the plurality of previous fourth frequency values of the main clock signal.

6. The method according to any of the previous claims, further comprising storing the plurality of first frequency values, the plurality of second frequency values, the plurality of third frequency values and the plurality of fourth frequency values of the main clock signal in a history log, wherein:

the plurality of first frequency values comprises a current first frequency value and a previously measured first frequency value;

the plurality of second frequency values comprises a current second frequency value and a previously measured second frequency value;

the plurality of third frequency values comprises a current third frequency value and a previously measured third frequency value; and

the plurality of fourth frequency values comprises a current fourth frequency value and a previously measured fourth frequency value.

7. The method according to any of the previous claims 2 to 6, wherein measuring the plurality of first frequency values of the main clock signal comprises filtering the plurality of first frequency values of the main clock signal and/or measuring the plurality of third frequency values of the main clock signal comprises filtering the plurality of third frequency values of the main clock signal.

8. An apparatus, comprising:

a first frequency measurement section configured to measure first frequency values of a main clock signal based on an external time signal;

a second frequency measurement section configured to measure second frequency values of the main clock signal based on a local reference signal; and

a frequency supervision section configured to:

determine a relative long-term frequency change between the main clock signal and the external time signal by comparing a measured first frequency value with one or more other first frequency values of the main clock signal; and

determine a relative frequency change between the main clock signal and the local reference signal by comparing a measured second frequency value with one or more other second frequency values of the main clock signal.

9. The apparatus according to claim 8, further comprising:

a time-base unit configured to receive the external time signal via a network;
a counter section comprising a counting unit configured to receive the main clock signal and to count a number of cycles of the main clock signal during a time interval, wherein the time interval is determined based on the received external time signal; and
a processing unit configured to calculate the first frequency value of the main clock signal based on the counted number of cycles of the main clock signal and the time interval.

10. The apparatus according to claim 9, wherein the counter section further comprises a memory configured to save a content of the counting unit associated with the counted number of cycles of the main clock signal upon receiving a pulse signal; the counter section being configured to:

transfer the content of the counting unit to the memory upon receiving the pulse signal; and
reset the counting unit upon transferring the content of the counting unit to the memory.

11. The apparatus according to claim 9, wherein the external time signal comprises a network-based time signal providing a time of day (ToD), the processing unit configured to:

send the pulse signal via an interface to the counter section;
read the ToD from the time-base unit; and
save the ToD as a first ToD value.

12. The apparatus according to claim 11, wherein the processing unit is further configured to:

read the content of the counting unit associated with the counted number of cycles of the main clock signal from the memory;
save the first ToD value as a second ToD value; and
calculate the first frequency value of the main clock signal based on the content of the counting unit and a difference between the first ToD and the second ToD value.

13. The apparatus according to claim 12, wherein the processing unit is configured to:

send the pulse signal via the interface to the counter section, read the ToD from the time-base unit and save the ToD as the first ToD value by a high-priority task; and read the content of the counting unit, save the first ToD value as the second ToD value and calculate the first frequency value of the main clock signal by a low-priority task.

14. The apparatus according to any of claims 8-13, wherein the external time signal comprises a network-based time signal with long-term stability in particular according to a Network Timing Protocol (NTP), further comprising a crystal oscillator configured to provide the local reference signal and/or an Oven Controlled Crystal Oscillator (OCXO) configured to provide the main clock signal.

15. The apparatus according to any of claims 8-14, further comprising a third frequency measurement section configured to measure third frequency values of the main clock signal based on a second external time signal and/or a fourth frequency measurement section configured to measure fourth frequency values of the main clock signal based on a second main clock signal.

100

101a        102a        103a

frequency to be measured    time-base

| OCXO_A | | Frequency-measurement | $f_{OCXO\_A}$, based on $f_{OCXO\_B}$ |

| OCXO_B | | Frequency-measurement | $f_{OCXO\_B}$, based on $f_{OCXO\_A}$ |

101b        102b        103b

Fig. 1

<u>200</u>

211a

CPU_A

frequency to be measured    time-base

221a

NTP_A 🌐                    Frequency-measurement    →  f$_{OCXO\_A}$, based on NTP_A

202a

232a

231a

OCXO_A ⊣[]⊢               Frequency-measurement    →  f$_{OCXO\_A}$, based on XO

201a

233                        212a                     222a

XO ⊣[]⊢

203

Fig. 2

300

measuring a plurality of first frequency values of the main clock signal based on an external time signal — S301

measuring a plurality of second frequency values of the main clock signal based on a local reference signal — S302

S303 — comparing the measured plurality of first frequency values of the main clock signal

S304 — comparing the measured plurality of second frequency values of the main clock signal

S305 — determining a relative long-term frequency change between the main clock signal and the external time signal

S306 — determining whether a relative frequency change exists between the main clock signal and the local reference signal

Fig. 3

400

frequency to be measured    time-base

CPU_A

402a  NTP_A  🕐  432a ● → Frequency-measurement ─411a
→ $f_{OCXO\_A}$, based on NTP_A   421a
─413a
→ Frequency-measurement
→ $f_{OCXO\_A}$, based on NTP_B   423a
401a  OCXO_A ─┤▯├─ 431a
─412a
→ Frequency-measurement
→ $f_{OCXO\_A}$, based on XO   422a
433
─414a
→ Frequency-measurement
→ $f_{OCXO\_A}$, based on $f_{OCXO\_B}$   424a
403  XO ─┤▯├─ ●

─414b
→ Frequency-measurement
→ $f_{OCXO\_B}$, based on $f_{OCXO\_A}$   424b
─412b
→ Frequency-measurement
→ $f_{OCXO\_B}$, based on XO   422b
401b  OCXO_B ─┤▯├─ 431b
─413b
→ Frequency-measurement
→ $f_{OCXO\_B}$, based on NTP_A   423b
─411b
402b  NTP_B  🕐  432b → Frequency-measurement
→ $f_{OCXO\_B}$, based on NTP_B   421b
CPU_B

Fig. 4

500

502
frequency to be measured

505

501

counter

result  504

time-base (*)

503

Fig. 5

<u>600</u>

603

601₁  601₂      601ₙ

NTP server  NTP server  · · ·  NTP server

CPU     Unstable ToD        Stable ToD

604

NTP software

LAN

602

605

Filter

stable & filtered ToD

Fig. 6

201

700

702
frequency to be measured
$f_{OCXO}$

705

counter 701

result   Hardware

711

703   Software
time-base

divider 706   $f_{OCXO}$   704

712

Fig. 7

800

Hardware 814

811 OCXO

counter 801

the "rising edge of read-pulse" transfers the contents of counter to memory and reset the counter

804 memory

Software 815

805 ↑ read-pulse

806 bus

803

802

NTP-SW 823

812 NTP from LAN

compare

ToD

accelerate decelerate

813 CPU_XO

frequency-converter

825

working-clock

824

GPIO-pin (General Purpose Input / Output )

high priority task

831

actual ToD 821

previous ToD 822

low priority task

832

Fig. 8

901

911                                                                912

16:09:34.000    16:09:35.000    16:09:36.000    16:09:37.000    16:09:38.000    16:09:39.000          16:26:15.000    16:26:16.000    16:26:17.000    16:26:18.000    ← millisecond 916
                                                                                                                                                                      ← second  915
                                                                                                                                                                      ← minute  914
ToD                                                                                                                                                                   ← hour  913

        931                925                              932                926
read-pulse

    923                                                 924

        921                                                 922

902

Fig. 9

Fig. 10

Fig. 11

Europäisches
Patentamt

European
Patent Office

Office européen
des brevets

## EUROPEAN SEARCH REPORT

Application Number

EP 16 30 5548

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | PODOGOVA SVETLANA ET AL: "Frequency combining system for atomic clock ensembles", 2014 EUROPEAN FREQUENCY AND TIME FORUM (EFTF), IEEE, 23 June 2014 (2014-06-23), pages 568-570, XP032813426, DOI: 10.1109/EFTF.2014.7331564 [retrieved on 2015-11-17] * figures 1,2 * * page 568, right-hand column, paragraph 2 - page 569, right-hand column, paragraph 2 * | 1-15 | INV. H04J3/14 G01R25/00 ADD. H04J3/06 H03D13/00 |
| X | US 4 899 117 A (VIG JOHN R [US]) 6 February 1990 (1990-02-06) * column 3, line 10 - line 23 * * column 5, line 58 - line 65 * * column 4, line 56 - column 5, line 18 * * column 6, line 2 - line 55 * * column 7, line 1 - line 3; figures 1,2 * * column 7, line 26 - line 55 * * figures 1,2 * | 1-15 | |
| X<br>Y | US 5 666 330 A (ZAMPETTI GEORGE PHILIP [US]) 9 September 1997 (1997-09-09) * column 4, line 49 - column 6, line 17; figures 3,5,7a * | 1,8-13<br>2-7,14, 15 | TECHNICAL FIELDS SEARCHED (IPC)<br>H04J G01R H03D |
| X | US 5 943 381 A (ZAMPETTI GEORGE PHILLIP [US]) 24 August 1999 (1999-08-24) * abstract; figures 2-5 * * column 4, line 26 - column 5, line 27 * | 1,8 | |

-/--

The present search report has been drawn up for all claims

| Place of search | Date of completion of the search | Examiner |
|---|---|---|
| The Hague | 10 November 2016 | Pieper, Thomas |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 3 244 557 A1**

Europäisches
Patentamt

European
Patent Office

Office européen
des brevets

# EUROPEAN SEARCH REPORT

Application Number

EP 16 30 5548

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | BOULTER R A: "SYSTEM X: SUBSYSTEMS PART 2 - THE NETWORK SYNCHRONIZATION SUBSYSTEM", POST OFFICE ELECTRICAL ENGINEERS JOURNAL, POST OFFICE ELECTRICAL ENGINEERS JOURNAL. LONDON, GB, vol. 73, 1 July 1980 (1980-07-01), pages 88-91,01, XP000844572, * figure 1 * | 2-7,14, 15 | |
| A | PAN J W: "PRESENT AND FUTURE OF SYNCHRONIZATION IN THE US TELEPHONE NETWORK", IEEE TRANSACTIONS ON ULTRASONICS, FERROELECTRICS AND FREQUENCY CONTROL, IEEE, US, vol. UFFC-34, no. 6, 1 November 1987 (1987-11-01), pages 629-638, XP000674126, ISSN: 0885-3010, DOI: 10.1109/T-UFFC.1987.26995 * page 630, right-hand column, paragraph 4 - page 635, right-hand column, paragraph 2; figure 3; table 1 * | 1-15 | |

-/--

TECHNICAL FIELDS
SEARCHED      (IPC)

The present search report has been drawn up for all claims

| Place of search | Date of completion of the search | Examiner |
|---|---|---|
| The Hague | 10 November 2016 | Pieper, Thomas |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | HANADO Y ET AL: "Upgrading of UTC(CRL)", PROCEEDINGS OF THE 2003 IEEE INTERNATIONAL FREQUENCY CONTROL SYMPOSIUM & PDA EXHIBITION JOINTLY WITH THE 17TH. EUROPEAN FREQUENCY AND TIME FORUM. TAMPA, FL, MAY 4 - 8, 2003; [IEEE INTERNATIONAL FREQUENCY CONTROL SYMPOSIUM], NEW YORK, NY : IEEE, US, 4 May 2003 (2003-05-04), pages 296-300, XP010688869, DOI: 10.1109/FREQ.2003.1275105 ISBN: 978-0-7803-7688-5 * abstract; figure 1 * * page 296, right-hand column - page 297, left-hand column, paragraph 2 * * page 299, right-hand column, last paragraph * * page 300 * | 1-15 | |
| A | MILLS D L: "IMPROVED ALGORITHMS FOR SYNCHRONIZING COMPUTER NETWORK CLOCKS", COMPUTER COMMUNICATION REVIEW, ACM, NEW YORK, NY, US, vol. 24, no. 4, 1 October 1994 (1994-10-01), pages 317-327, XP000477058, ISSN: 0146-4833, DOI: 10.1145/190809.190343 * page 322, right-hand column, paragraph 3 - page 324, left-hand column, paragraph 4 * | 1,8 | TECHNICAL FIELDS SEARCHED (IPC) |

The present search report has been drawn up for all claims

| Place of search | Date of completion of the search | Examiner |
|---|---|---|
| The Hague | 10 November 2016 | Pieper, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 16 30 5548

This annex lists the patent family members relating to the patent documents cited in the above-mentioned European search report.
The members are as contained in the European Patent Office EDP file on
The European Patent Office is in no way liable for these particulars which are merely given for the purpose of information.

10-11-2016

| Patent document cited in search report | | Publication date | Patent family member(s) | | Publication date |
|---|---|---|---|---|---|
| US 4899117 | A | 06-02-1990 | CA | 1305611 C | 28-07-1992 |
| | | | US | 4899117 A | 06-02-1990 |
| US 5666330 | A | 09-09-1997 | CA | 2195459 A1 | 08-02-1996 |
| | | | EP | 0771438 A1 | 07-05-1997 |
| | | | JP | H10503282 A | 24-03-1998 |
| | | | US | 5666330 A | 09-09-1997 |
| | | | WO | 9603679 A1 | 08-02-1996 |
| US 5943381 | A | 24-08-1999 | AU | 726497 B2 | 09-11-2000 |
| | | | AU | 2824797 A | 26-11-1997 |
| | | | CA | 2253461 A1 | 13-11-1997 |
| | | | CN | 1217097 A | 19-05-1999 |
| | | | EP | 0896762 A1 | 17-02-1999 |
| | | | JP | 2000510668 A | 15-08-2000 |
| | | | US | 5751777 A | 12-05-1998 |
| | | | US | 5943381 A | 24-08-1999 |
| | | | WO | 9742710 A1 | 13-11-1997 |

EPO FORM P0459

For more details about this annex : see Official Journal of the European Patent Office, No. 12/82